# EUROPEAN PATENT APPLICATION

(11) **EP 4 832 681 A1**
(43) Date of publication of application: **28.10.2026**
(21) Application number: 25179111.7
(22) Date of filing: 27.05.2025
(51) Int. Cl.: H05K 7/20

(54) **POWER CONVERSION SYSTEM AND ENERGY STORAGE SYSTEM**

(30) Priority: 27.04.2025 CN 202510541396
(71) Applicant: Zhejiang Jinko Energy Storage Co., Ltd., Jiaxing, Zhejiang 314415 (CN)
(72) Inventor: LU, Yang, Haining (CN); XU, Guodong, Haining (CN); YU, Jian, Haining (CN); SUN, Xuebing, Haining (CN); CHENG, Min, Haining (CN); ZHANG, Luhua, Haining (CN)
(74) Representative: Haseltine Lake Kempner LLP

(57) **Abstract**

Disclosed are a power conversion system (PCS, 10) and an energy storage system. The PCS (10) includes: a thermal management component (11) having a fluid passage (LP), and having a first side (f1) and a second side (f2) opposite to each other along a first direction (D1); a plurality of elements (12) disposed on the first side (f1); and an air-cooling module (13) disposed on the first side (f1). The air-cooling module (13) includes a fan (131) and a radiator (132), the radiator (132) includes a main body portion (1321) and a plurality of insertion members (1322) arranged at intervals, the main body portion (1321) is located on a path of an airflow generated by the fan (131), the insertion members (1322) are disposed on a side of the main body portion (1322) facing the thermal management component (11) along the first direction (D1).

## Description

### TECHNICAL FIELD

The present application relates to the technical field of energy storage, in particular to a power conversion system and an energy storage system.

### BACKGROUND

A power conversion system (PCS) is one of the core equipment in an energy storage system. With the rapid development of the energy storage technology, the power of the PCS is constantly increased, and the power consumption of the elements inside the PCS is also constantly increased, which leads to the continuous increase of the heat generation of these elements, and further makes the thermal management requirements of the PCS increasingly high. Therefore, how to improve the thermal management effect of the PCS is an urgent problem to be solved.

### SUMMARY

In view of the problem above, it is necessary to provide a power conversion system and an energy storage system to improve the thermal management effect of the PCS.

In an aspect of the present invention, a power conversion system (PCS) is provided. The PCS includes a thermal management component, a plurality of elements, and an air-cooling module. The thermal management component has a fluid passage, and has a first side and a second side opposite to each other along a first direction. The plurality of elements are disposed on the first side. The air-cooling module is disposed on the first side. The air-cooling module includes a fan and a radiator. The radiator includes a main body portion and a plurality of insertion members arranged at intervals. The main body portion is located on a path of an airflow generated by the fan. The plurality of insertion members are disposed on a side of the main body portion facing the thermal management component along the first direction. The plurality of insertion members are configured to be inserted into the fluid passage.

In some embodiments, the fluid passage includes a first buffer section and a main section. The first buffer section communicates with an inlet of the fluid passage. The main section communicates with the first buffer section and an outlet of the fluid passage. An orthographic projection of the main section on a reference plane overlaps with an orthographic projection of the plurality of elements on the reference plane, and the reference plane is perpendicular to the first direction. The plurality of insertion members are configured to be inserted into the first buffer section.

In some embodiments, an extending direction of the fluid passage from the inlet of the fluid passage to the outlet of the fluid passage is a reference direction. In the reference direction, a distribution density of the plurality of insertion members per unit space region in the fluid passage tends to decrease.

Optionally, in the reference direction, the distribution density of the plurality of insertion members per unit space region in the fluid passage decreases by steps.

In some embodiments, an inlet of the fluid passage and an outlet of the fluid passage are located on the same side of the thermal management component. The fluid passage includes a first buffer section, a second buffer section, and a main section that communicates with the first buffer section and the second buffer section. The first buffer section communicates with the inlet of the fluid passage, and the second buffer section communicates with the outlet of the fluid passage. An orthographic projection of the main section on a reference plane overlaps with an orthographic projection of the plurality of elements on the reference plane, and the reference plane is perpendicular to the first direction. A part of the plurality of insertion members are configured to be inserted into the first buffer section, and another part of the plurality of insertion members are configured to be inserted into the second buffer section.

In some embodiments, an extending direction of the fluid passage from the inlet of the fluid passage to the outlet of the fluid passage is a reference direction. In the reference direction, a distribution density of the part of the plurality of insertion members per unit space region in the first buffer section, tends to decrease.

Optionally, in the reference direction, the distribution density of the part of the plurality of insertion members per unit space region in the first buffer section decreases by steps.

In some embodiments, an extending direction of the fluid passage from the inlet of the fluid passage to the outlet of the fluid passage is a reference direction. In the reference direction, a distribution density of the other part of the plurality of insertion members per unit space region in the second buffer section tends to increase.

Optionally, in the reference direction, a distribution density of the other part of the plurality of insertion members per unit space region in the second buffer section increases by steps.

In some embodiments, the PCS further includes a housing body. The housing body has an accommodating cavity. The thermal management component is disposed in the accommodating cavity. The first side of the thermal management component and a cavity wall of the accommodating cavity define a receiving cavity. The plurality of elements and the air-cooling module are disposed in the receiving cavity. A plurality of fans are provided, the plurality of fans are configured to generate a circulating airflow around an axis in the receiving cavity, the main body portion is located on a path of the circulating airflow, and an extending direction of the axis and the first direction are parallel to each other.

In some embodiments, at least three fans are provided. The at least three fans are configured to generate two circulating airflows s arranged in a second direction in the receiving cavity. The first direction and the second direction intersect with each other.

In some embodiments, the thermal management component has a first area, a second area and a third area arranged along the second direction. The at least three fans are arranged in the first area, the second area and the third area. A fan disposed in the first area is defined as a first fan, a fan disposed in the second area is defined as a second fan, and a fan disposed in the third area is defined as a third fan. The main body portion is located on a path of an airflow generated by the second fan. The first fan and the second fan are configured to generate a circulating airflow, and the second fan and the third fan are configured to generate another circulating airflow.

In some embodiments, the plurality of elements are arranged in the first area, the second area, and the third area. An average heat generation of elements provided in the first area and an average heat generation of elements provided in the third area are both less than an average heat generation of elements provided in the second area.

In some embodiments, the main body portion includes at least one column of fins arranged at intervals along the first direction. Each column of fins defines spacing channels. An inlet side of the second fan is connected to a side of the main body portion, and an inlet of the second fan communicates with the spacing channels.

In some embodiments, the thermal management component has a first edge and a second edge opposite to each other in a third direction. The first direction, the second direction, and the third direction intersect with each other. The second fan is disposed closer to the first edge than the second edge. The first fan and the third fan are disposed closer to the second edge than the first edge.

In some embodiments, the main body portion includes at least one column of fins arranged at intervals along the first direction. Each column of fins defines spacing channels. An inlet side of one of the plurality of fans is connected to a side of the main body portion, and an inlet of the one of the plurality of fan communicates with the spacing channels.

In some embodiments, the first side of the thermal management component includes a plurality of installation areas. The PCS further includes a plurality of temperature equalization plates. The plurality of temperature equalization plates are arranged in the plurality of installation areas in a one-to-one correspondence. The plurality of temperature equalization plates are arranged in a one-to-one correspondence with at least some of the plurality of elements, and each of the least some of the plurality of elements is installed on a side of a corresponding temperature equalization plate facing away from the thermal management component.

In another aspect of the present invention, an energy storage system is provided. The energy storage system includes the PCS of any of the above embodiments.

In the PCS and the energy storage system, the PCS at least includes a thermal management component, an element and an air-cooling module. The air-cooling module includes a fan and a radiator. By configuring the radiator to include the main body portion and the plurality of insertion members, and by inserting the insertion members into the fluid passage of the thermal management component, not only the insertion members can be further cooled by the coolant in the fluid passage, but also the coolant in the fluid passage can be disturbed by the insertion members, which would extend the time for the coolant to pass through the insertion members, thereby further improving the cooling effect of the coolant on the insertion members, so that the main body portion can be cooled. Since the radiator is located on the path of the airflow generated by the fan, the airflow generated by the fan can be cooled by passing through the main body portion, so that the elements on the first side of the thermal management component can be cooled, thereby further improving the heat management effect of the PCS.

Additional aspects and advantages of the embodiments of the present application will be partially presented in the following description, some of which will become apparent from the following description, or learned through practicing the embodiments of the present application.

### BRIEF DESCRIPTION OF THE DRAWINGS

Various other advantages and benefits will become apparent to those of ordinary skill in the art through reading the detailed description of the embodiments below. The drawings are used for the purpose of illustrating embodiments only but not considered as limitations to the present application. In the drawings, same elements are indicated by same reference numerals. In the drawings:
FIG. 1 is a schematic view illustrating a three-dimensional structure of a PCS according to some embodiments of the present invention;
FIG. 2 is a schematic view illustrating a three-dimensional structure of the PCS according to some embodiments of the present invention, where some parts are removed;
FIG. 3 is a three-dimensional structural view illustrating a structure shown in FIG. 2, where some parts are removed;
FIG. 4 is a schematic view illustrating a three-dimensional structure of a thermal management component according to some embodiments of the present invention;
FIG. 5 is a schematic view illustrating an exploded structure of the thermal management component according to some embodiments of the present invention;
FIG. 6 is a view illustrating a top viewed structure of the thermal management component according to some embodiments of the present invention;
FIG. 7 is a schematic view illustrating a three-dimensional structure of a radiator according to some embodiments of the present invention;
FIG. 8 is a schematic structural view illustrating a radiator, a fan and some parts of a thermal management component engaging with each other according to some embodiments of the present invention;
FIG. 9 is a schematic view illustrating a projection relationship between elements and a main section according to some embodiments of the present invention;
FIG. 10 is a view illustrating a top viewed structure showing a distribution state of insertion members according to some embodiments of the present invention;
FIG. 11 is a three-dimensional structural view illustrating a distribution state of the insertion members according to other embodiments of the present invention;
FIG. 12 is a view illustrating a top viewed structure showing a distribution state of insertion members according to other embodiments of the present invention;
FIG. 13 is a three-dimensional structural view showing a distribution state of the insertion members according to still other embodiments of the present invention;
FIG. 14 is a view illustrating a top viewed structure showing a distribution state of the insertion members according to still other embodiments of the present invention;
FIG. 15 is a schematic structural view showing a distribution state of the insertion members according to yet still other embodiments of the present invention;
FIG. 16 is a view illustrating a top viewed structure showing a distribution state of the insertion members according to yet still other embodiments of the present invention;
FIG. 17 is a view illustrating a top viewed structure showing a distribution state of the insertion members according to yet still other embodiments of the present invention;
FIG. 18 is a view illustrating a top viewed structure showing a distribution state of the insertion members according to yet still other embodiments of the present invention;
FIG. 19 is a view illustrating a top viewed structure of the structure shown in FIG. 2;
FIG. 20 is a schematic view illustrating a structure having a plurality of fans, which cooperate with each other to form a circulating airflow, according to some embodiments of the present invention;
FIG. 21 is a schematic view illustrating a three-dimensional structure having a radiator and a second fan engaging with each other according to some embodiments of the present invention;
FIG. 22 is a three-dimensional structural view showing a main body portion of a radiator and a fan engaging with each other according to other embodiments of the present invention; and
FIG. 23 is a view illustrating a top viewed structure of the main body portion of the radiator and the fan engaging with each other according to other embodiments of the present invention.

Description of reference signs:
10, power conversion system;
11, thermal management component; 111, first body; k, through hole; 112, second body; LP, fluid passage; LP1, first buffer section; LP2, main section; LP3, second buffer section; f1, first side; f2, second side; A1, first area; A2, second area; A3, third area; X, installation area; b1, first edge; b2, second edge;
12, element;
13, air-cooling module; 131, fan; 131a, first fan; 131b, second fan; 131c, third fan; 132, radiator; 1321, main body portion; e, fin; t1, first end; t2, second end; GP, spacing channel; 1322, insertion member;
14, housing body; 141, first portion; 142, second portion;
15, temperature equalization plate;
16, circuit board assembly;
J1, inlet connector; J2, outlet connector;
M, reference plane; s1, first projection; s2, second projection;
D1, first direction; D2, second direction; and D3, third direction.

### DETAILED DESCRIPTION OF THE EMBODIMENTS

In order to make the objectives, features, and advantages of the present application more apparent and understandable, the specific implementations of the present application will be explained in detail below in conjunction with the accompanying drawings. In the following description, numerous specific details are set forth in order to facilitate a thorough understanding of the present application. However, the present application can be implemented in many other ways different from those described herein, and those skilled in the art can make similar modifications without departing from the connotation of the application, therefore the present application is not limited to the specific embodiments disclosed below.

In the description of the present application, it would be understood that if there are the terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc., they indicate the orientations or positional relationships on the basis of the drawings. These terms are only intended to facilitate illustrating the present application and simplify the illustration, rather than indicate or imply that related devices or elements necessarily have present particular orientations and are constructed and operated in particular orientations, and therefore these terms cannot be construed as limitation on the present application.

In addition, if the terms "first" and "second" appear, they are only used for illustrative purposes, rather than be construed as indicating or implying relative importance or implicitly designate the number of the related technical features. Thus, the features defined by "first" and "second" may explicitly or implicitly include at least one said feature. In the description of the present application, if there is the term "a plurality of", it means at least two, for example two or three, etc., unless otherwise explicitly and specifically defined.

In the present application, unless otherwise expressly specified and defined, if there are the terms "mounted", "connected to", "coupled" and "fixed", they should be understood in a broad manner to be: for example, fixedly connected or detachably connected, or integrated; mechanically connected or electrically connected; directly connected or indirectly connected through an intermediate medium, or an interior communication or mutual interaction relationship between two elements, unless otherwise specifically defined. For those of ordinary skill in the art, the specific meanings of the above-described terms in the present application may be understood according to specific circumstances.

In the present application, unless otherwise expressly stated and defined, the first feature, when described as being located "above" or "below" the second feature, may be in direct contact with the second feature, or in indirect contact with the second feature via an intermediate feature. Moreover, the first feature, when described as being disposed "on", "above" and "over" the second feature, may be disposed right above or obliquely above the second feature, or simply disposed at a level higher than the second feature. The first feature, when described as being disposed "under", "below" and "beneath" the second feature, may be disposed directly below or obliquely below the second feature, or simply disposed at a level lower than the second feature.

It should be noted that, if an element is described as being "fixed to" or "disposed on" another element, the element may be directly on the other element, or there may also be an intermediate element. If an element is described as being "connected" to another element, it may be directly connected to the other element, or there may be an intermediate element as well. If the terms "vertical", "horizontal", "up", "down", "left", "right" and similar expressions are used herein, they are only for the purpose of illustration, rather than present the only implementation.

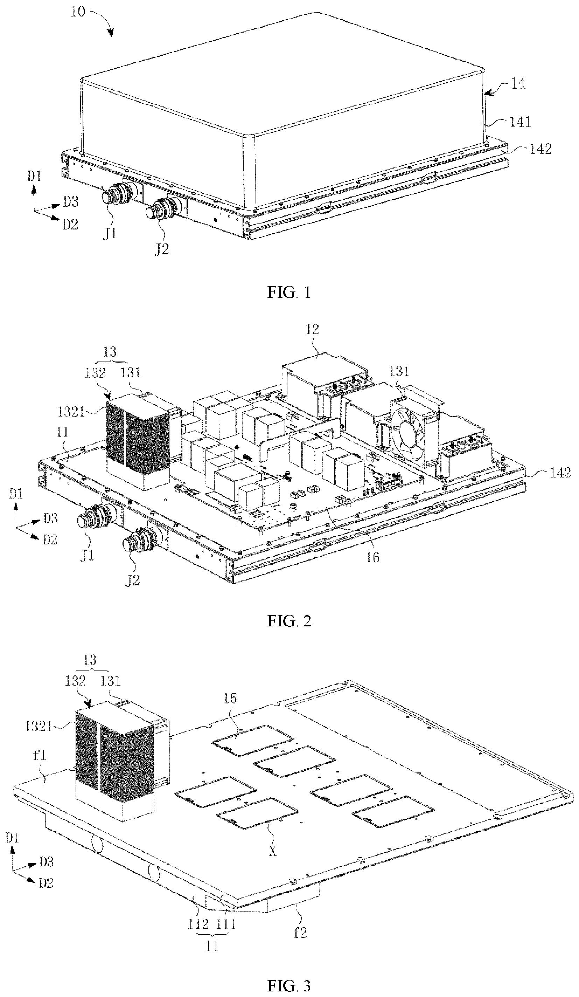

According to some embodiments of the present invention, referring to FIG. 1, FIG. 2 and FIG. 3, FIG. 1 is a schematic view illustrating a three-dimensional structure of a power conversion system (PCS) 10 according to some embodiments of the present invention, FIG. 2 is a schematic view illustrating a three-dimensional structure of the PCS 10 according to some embodiments of the present invention, where some parts are removed, and FIG. 3 is a three-dimensional structural view illustrating a structure shown in FIG. 2, where some parts are removed. An embodiment of the present invention provides a PCS 10, including a thermal management component 11, a plurality of elements 12, and an air-cooling module 13.

The thermal management component 11 is provided with a fluid passage LP, and has a first side f1 and a second side f2 opposite to each other in a first direction D1. The thermal management component 11 is configured to control and manage heat quantity. The fluid passage LP is configured for a coolant to pass through. The fluid passage LP enables the thermal management component 11 to take advantage of the thermal capacity and fluidity of the coolant to achieve an efficient heat exchange. The coolant, when flowing in the fluid passage LP, can continuously absorb or release heat, thereby making a sufficient heat exchange with various parts of the thermal management component 11.

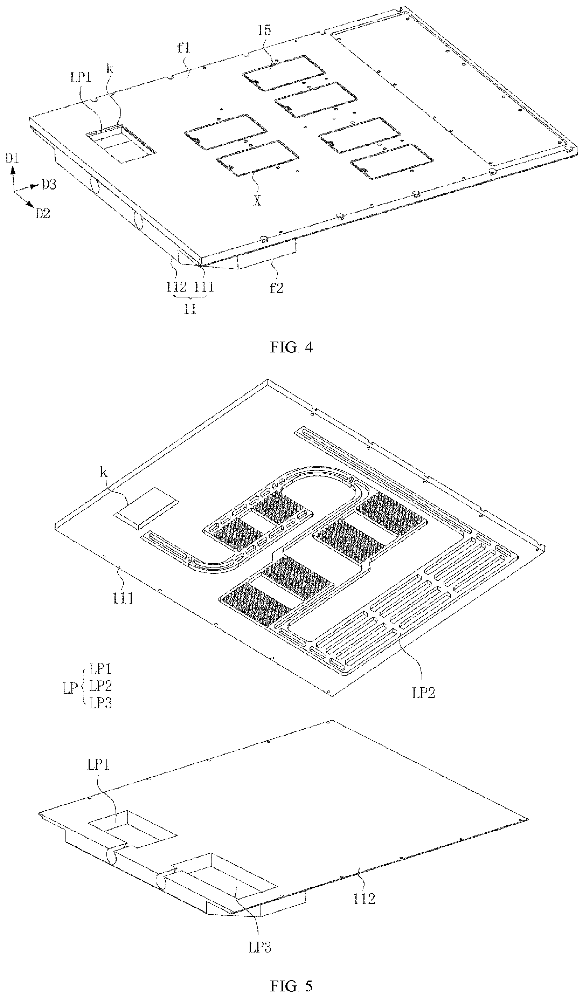

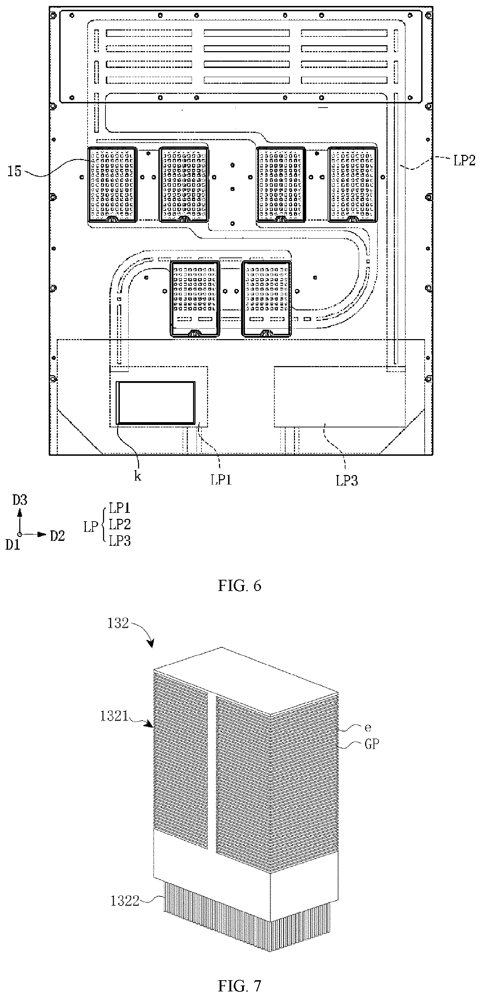

Exemplarily, referring to FIG. 4 to FIG. 6, FIG. 4 is a schematic view illustrating a three-dimensional structure of a thermal management component 11 according to some embodiments of the present invention, FIG. 5 is a schematic view illustrating an exploded structure of the thermal management component 11 according to some embodiments of the present invention, and FIG. 6 is a view illustrating a top viewed structure of the thermal management component 11 according to some embodiments of the present invention. The thermal management component 11 may include a first body 111 and a second body 112 disposed along the first direction D1. A side of the first body 111 and a side of the second body 112 facing each other defines the fluid passage LP. It may be that the side of the first body 111 facing the second body 112 is partially recessed to form the fluid passage LP, or it may be that the side of the second body 112 facing the first body 111 is partially recessed to form the fluid passage LP, or it may be that each of the side of the first body 111 and the side of the second body 112 facing each other is partially recessed to form the fluid passage LP. In the case illustrated in FIG. 5, each of the side of the first body 111 and the side of the second body 112 facing each other is partially recessed to form the fluid passage LP. FIG. 5 illustrates the side of the first body 111 and the side of the second body 112 facing each other. In FIG. 6, the fluid passage LP located inside the thermal management component 11 is illustrated with dashed lines.

A plurality of elements 12 are disposed on the first side f1. The elements 12 refer to various electronic components, parts, or components that may be used to constitute electronic equipment, circuitry, or other apparatuses. The elements 12 may include a capacitor, a relay, a transformer, a Hall element, an insulated gate bipolar transistor (IGBT) module, and a power transistor, and the like, which are not specifically limited herein. The elements 12 are disposed on the first side f1 of the thermal management component 11, that is, the heat exchange can be performed between the plurality of elements 12 and the thermal management component 11.

The air-cooling module 13 is provided on the first side f1. The air-cooling module 13 includes a fan 131 and a radiator 132. Referring to FIG. 7, FIG. 7 is a view illustrating a three-dimensional structure of a radiator 132 according to some embodiments of the present invention. The radiator 132 includes a main body portion 1321 and a plurality of insertion members 1322 arranged at intervals. The main body portion 1321 is located on a path of an airflow generated by the fan 131. A plurality of insertion members 1322 are disposed on a side of the main body portion 1321 facing the thermal management component 11 along the first direction D1. The plurality of insertion members 1322 are inserted into the fluid passage LP.

The air-cooling module 13 is configured to dissipate heat, and mainly includes the fan 131 and the radiator 132. The fan 131 generates airflow by rotating the blades of the fan 131, thereby promoting the air to flow. The main body portion 1321 of the radiator 132 is located on the path of the airflow generated by the fan 131, so as to better take advantage of the forced convection generated by the fan 131 to improve the heat exchange effect between the airflow and the radiator 132. The plurality of insertion members 1322 disposed on the main body portion 1321 can be inserted into the fluid passage LP of the thermal management component 11, so that the radiator 132 can be more closely coupled to the thermal management component 11, and that the radiator 132 can directly exchange heat with the coolant in the fluid passage LP, thereby improving the heat exchange efficiency. Exemplarily, each insertion member 1322 may be configured as a cylindrical member, a block-shaped member, or a member in other forms, which is not specifically limited herein.

Therefore, by configuring the radiator 132 to include the main body portion 1321 and the plurality of insertion members 1322, and by inserting the insertion members 1322 into the fluid passage LP of the thermal management component 11, not only the insertion members 1322 can be further cooled by the fluid in the fluid passage LP, but also the flow of the coolant in the fluid passage LP can be disturbed by the insertion members 1322, which would extend the time duration for the coolant to pass through the insertion members 1322, thereby further improving the cooling effect of the coolant on the insertion members 1322, so that the main body portion 1321 can be cooled. Since the radiator 132 is located on the path of the airflow generated by the fan 131, the airflow generated by the fan 131 can be cooled when passing through the main body portion 1321, so that the elements 12 on the first side f1 of the thermal management component 11 can be cooled, thereby further improving the heat management effect of the PCS 10.

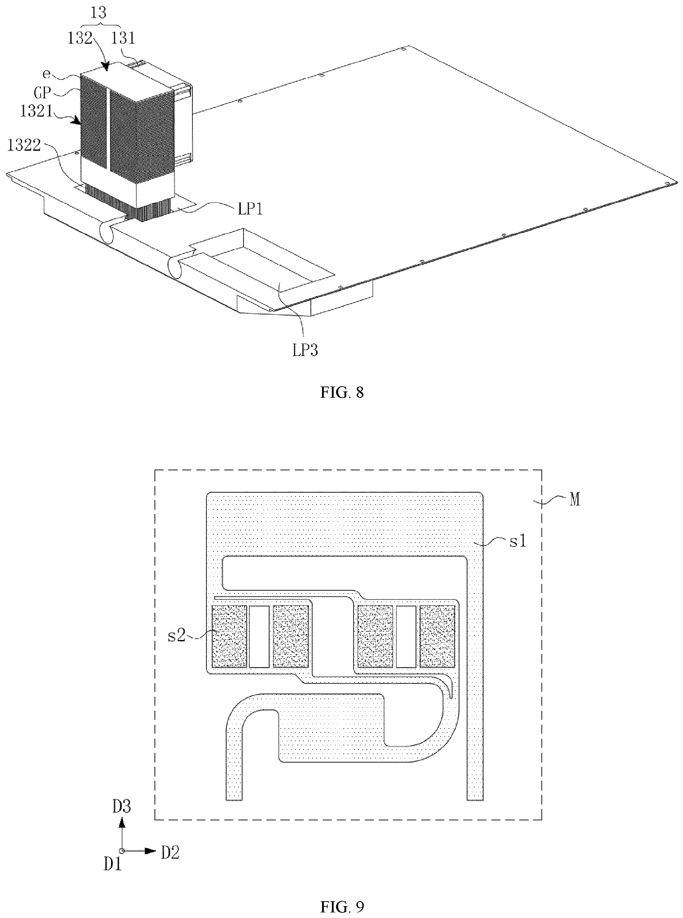

According to some embodiments of the present invention, referring to FIG. 4 to FIG. 6, in combination with FIG. 8 and FIG. 9, FIG. 8 is a schematic structural view illustrating a radiator 132, a fan 131 and some parts of a thermal management component 11 engaging with each other according to some embodiments of the present invention, and FIG. 9 is a schematic view illustrating a projection relationship between elements 12 and a main section LP2 according to some embodiments of the present invention. The fluid passage LP includes a first buffer section LP1 and a main section LP2. The first buffer section LP1 communicates with an inlet of the fluid passage LP, and the main section LP2 communicates with the first buffer section LP1 and an outlet of the fluid passage LP. An orthographic projection of the main section LP2 on a reference plane *M* overlaps with an orthographic projection of the plurality of elements 12 on the reference plane *M,* and the reference plane *M* is a plane perpendicular to the first direction D1. The plurality of insertion members 1322 are inserted into the first buffer section LP1.

Specifically, referring to FIG. 9, the orthographic projection of the main section LP2 on the reference plane *M* is a first projection s1, and the orthographic projection of the plurality of elements 12 on the reference plane *M* is a second projection s2. It can be seen that the first projection s1 overlaps with the second projection s2. Taking FIG. 9 as an example, the case where the second projection s2 is located within the first projection s1 is illustrated. Alternatively, other cases are also possible, for example, a part of the second projection s2 may be located within the first projection s1, and another part of the second projection s2 may be located outside the first projection s1, which is not specifically limited herein.

The orthographic projection of the main section LP2 on the reference plane *M* overlaps with the orthographic projection of the plurality of elements 12 on the reference plane *M,* which means that the main section LP2 of the fluid passage LP can be much closer to the elements 12, so that the coolant can more directly absorb the heat generated by the elements 12, thereby further effectively reducing the temperature of the elements 12, and improving the working performance and stability of the elements 12. In some embodiments, a spoiler structure may be disposed on the main section LP2 to further improve the heat exchange effect between the main section LP2 and the elements 12.

The first buffer section LP1 is a structure having a certain volume, and configured to adjust and buffer a flow state of the coolant. The first buffer section LP1 may be formed by widening a portion of the fluid passage LP, or may be a separate chamber communicating with the fluid passage LP. Taking FIG. 6 as an example, FIG. 6 illustrates the case where the first buffer section LP1 is formed by widening a portion of the fluid passage LP.

The plurality of insertion members 1322 are inserted into the first buffer section LP1 to buffer and pre-adjust the coolant before the coolant enters the main section LP2. In this way, before entering the main section LP2, the coolant has a more uniform and stable flow rate, which helps to improve the heat exchange efficiency between the coolant in the main section LP2 and the heat generating elements 12, so that the coolant can more sufficiently absorb the heat when passing through the main section LP2, thereby further improving the heat exchange effect. In addition, the more uniform and stable flow rate is also beneficial for more sufficient heat exchange between the insertion members 1322 and the coolant in the first buffer section LP1, thereby helping to improve the heat dissipating effect of the air-cooling assembly on the related components disposed on the first side f1 of the thermal management component 11.

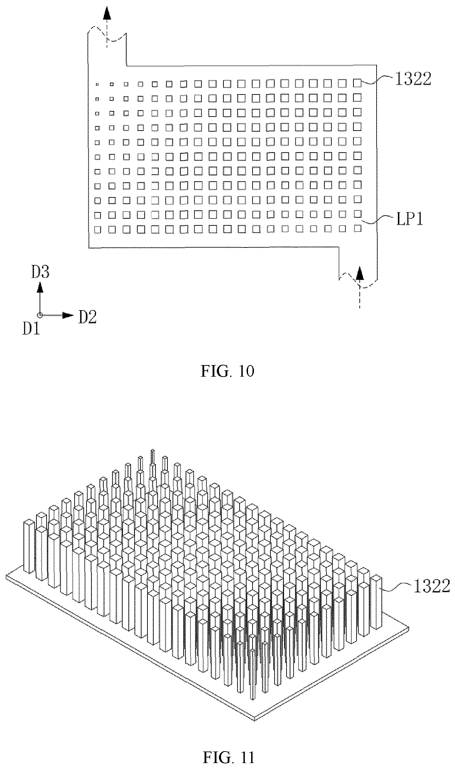

According to some embodiments of the present invention, referring to FIG. 10, FIG. 10 is a view illustrating a top viewed structure showing a distribution state of insertion members 1322 according to some embodiments of the present invention. The extending direction of the fluid passage LP from the inlet of the fluid passage LP to the outlet of the fluid passage LP is a reference direction. In the reference direction, a distribution density of the plurality of insertion members 1322 per unit space region in the fluid passage LP tends to decrease. In FIG. 10, the inflow and outflow directions of the coolant are indicated by arrows.

The Unit space region means a space range with a target quantity within the space defined by the fluid passage LP, that is, the unit space region is a region having a target volume. For example, the fluid passage LP may be divided into several cubic regions of the same size, each of which may be considered as a unit space region.

The distribution density per unit space region is used to indicate the density of the insertion members 1322. For example, the distribution density per unit space region refers to the spatial proportion occupied by the insertion members 1322 within per unit space region. If all the insertion members 1322 have the same size and the insertion members 1322 in per unit space region are all completely located within the unit space region, the space occupied by the insertion members 1322 in the unit space region is equal to a multiplication of the number of the insertion members 1322 in such unit space region multiplied by the space occupied by a single insertion member 1322. If all the insertion members 1322 are not of the same size, and some of the insertion members 1322 are located within the unit space region completely and some of the insertion members 1322 are located within the unit space region incompletely, the space occupied by the insertion members 1322 in of the unit space region is the sum of the total space occupied by all the insertion members 1322 completely located in the unit space region and the total space occupied by all the insertion members 1322 incompletely located in the unit space region. The smaller the distribution density of the insertion members 1322 in the unit space region, the sparser the distribution of the insertion members 1322; and the greater the distribution density of the insertion members 1322 in the unit space region, the denser the distribution of the insertion members 1322. The size and shape of the selected unit space region depend on different sizes defined for the unit space region. After the size of the unit space region is defined, the size of the unit space region has a relative size and shape. For example, the size of the unit space region may be 1 cm³, 1 mm³, 1100 mm³, etc., which is not specifically limited in this embodiment of the present invention. It would be understood that all units of space region have the same shape and the same size.

In the reference direction, the distribution density of the plurality of insertion members 1322 per unit space region in the fluid passage LP tends to decrease, that is, the distribution of the insertion members 1322 shows a trend of becoming sparser in the reference direction.

In this way, the distribution density of the insertion members 1322 closer to the inlet of the fluid passage LP is relatively large, so that a contact area between the coolant and the insertion members 1322 can be increased, thereby prolonging a contact time of the coolant and the insertion members 1322, which can facilitate more thorough heat exchange, and improve the heat dissipating effect of the air-cooling module 13 on the related components located on the first side f1 of the thermal management component 11. moreover, because the temperature of the coolant is relatively low when the coolant enters the fluid passage LP, when the coolant comes into the region with a relatively large distribution density of the insertion members 1322, part of cooling capacity thereof can be transferred to the radiator 132, so that when the coolant subsequently flows through the main section LP2 and comes into contact with the elements 12, the temperature difference therebetween is relatively reduced, which helps to reduce the thermal stress and minimize the damages to the elements 12 caused by excessive temperature differences. It can be understood that the combination of the air-cooling module 13 and the coolant is beneficial to improve the temperature equalization of the elements 12. Further, by controlling the distribution density of the insertion members 1322, the coolant entering the fluid passage LP can be preliminarily divided and combined, so that the coolant is more uniformly distributed in the fluid passage LP. Along with the coolant flowing to the outlet of the fluid passage LP, the distribution density of the insertion members 1322 gradually decreases, so that the flowing coolant maintains a relatively stable distribution state, thereby further improving the uniformity of the heat dissipation.

According to some embodiments of the present invention, continuing to refer to FIG. 10, in the reference direction, the distribution density of the plurality of insertion members 1322 per unit space region in the fluid passage LP gradually decreases.

When the coolant flows in the fluid passage LP, a velocity, a pressure and other characteristics thereof will change along the flow direction. In general, as the coolant flows from the inlet of the fluid passage LP to the outlet of the fluid passage LP, the velocity and pressure thereof gradually decrease. By setting the distribution density of the insertion members 1322 to be gradually decreased, thereby being better adapted to the change of the fluid characteristics. In this way, it is possible to facilitate the flow of the coolant in the flow passage while improving the aforementioned temperature equalization.

In some other embodiments, the distribution density of the plurality of insertion members 1322 per unit space region in the fluid passage LP may decrease by steps along the reference direction. By adjusting the distribution density of the insertion members 1322 by steps, the flow rate, flow direction and turbulence degree of the coolant can be controlled at different stages, which is not limited specifically herein.

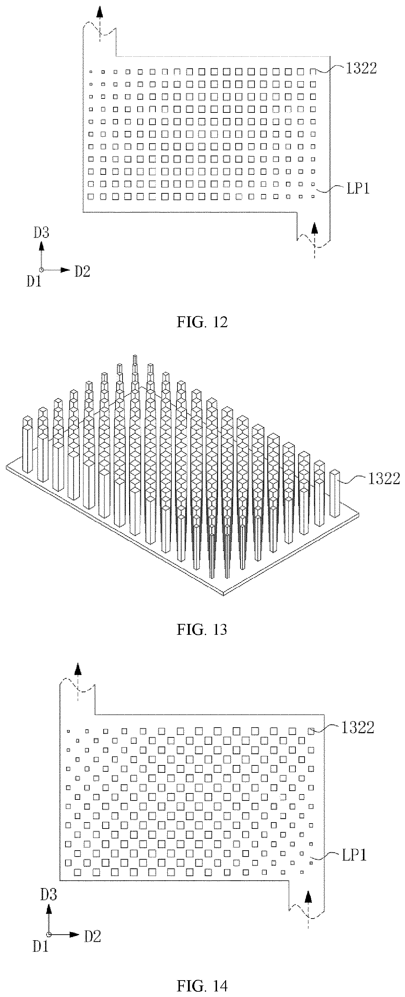

According to some embodiments of the present invention, referring to FIG. 11 and FIG. 12 for the following description, FIG. 11 is a three-dimensional structure view showing a distribution state of the insertion members 1322 according to other embodiments of the present invention, and FIG. 12 is a view illustrating a top viewed structure showing a distribution state of insertion members 1322 according to other embodiments of the present invention. The extending direction of the fluid passage LP from the inlet of the fluid passage LP to the outlet of the fluid passage LP is the reference direction. In the reference direction, the distribution density of the plurality of insertion members 1322 per unit space region in the fluid passage LP tends to increase first and then decrease. In FIG. 12, the inflow and outflow directions of the coolant are indicated by arrows.

In this way, the distribution of the insertion members 1322 shows a trend of becoming denser first and then becoming sparser. In this way, the distribution of the insertion members 1322 close to the inlet and outlet is relatively sparse, and the distribution of the insertion members 1322 located in the middle portion is relatively dense. Therefore, in addition to the advantages of improving the heat dissipation uniformity and the like as described above, the clogging of the coolant when the coolant comes into contact with and leaves the insertion members is improved, but also the heat exchange effect of the airflow is improved by the coolant exchanging heat with some of the insertion members 1322 in the middle portion.

According to some embodiments of the present invention, continuing to refer to FIG. 10 to FIG. 12, all the insertion members 1322 are arranged in rows along a second direction D2 and arranged in columns along a third direction D3. The first direction D1, the second direction D2, and the third direction D3 intersect with each other. Exemplarily, the first direction D1, the second direction D2, and the third direction D3 are perpendicular to each other.

In this way, the insertion members 1322 are regularly arranged, which is beneficial to control the distribution density of the insertion members 1322.

According to some embodiments of the present invention, referring to FIG. 13 and FIG. 14, FIG. 13 is a three-dimensional structural view showing a distribution state of the insertion members according to still other embodiments of the present invention, and FIG. 14 is a view illustrating a top viewed structure showing a distribution state of the insertion members according to still other embodiments of the present invention, where all the insertion members 1322 are arranged irregularly.

In this way, by irregularly arranging the insertion members 1322, the effect of the heat exchange between the coolant and the insertion members 1322 is further improved.

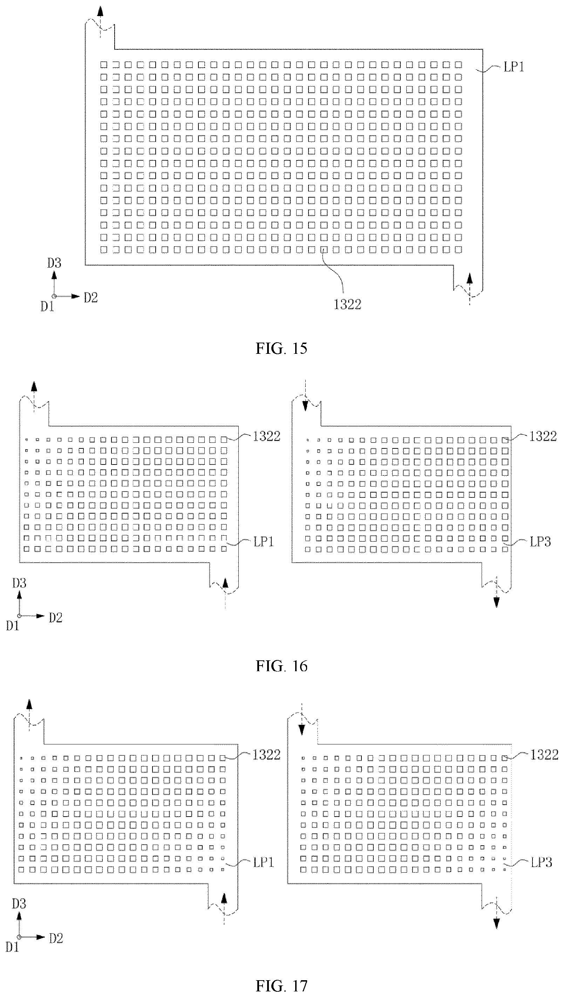

In some other embodiments of the present invention, continuing to refer to FIG. 15, FIG. 15 is a schematic structural view showing a distribution state of the insertion members according to yet still other embodiments of the present invention. The distribution density of the insertion members 1322 may be consistent. All of the insertion members 1322 may be arranged in a rectangular array, and the distance between each two adjacent insertion members 1322 is the same, which makes arranging the insertion members 1322 on the main body portion 1321 easily, which is not limited specifically herein.

According to some embodiments of the present invention, continuing to refer to FIG. 4 to FIG. 6, in combination with FIG. 16, FIG. 16 is a view illustrating a top viewed structure showing a distribution state of the insertion members according to yet still other embodiments of the present invention, where the inlet of the fluid passage LP and the outlet of the fluid passage LP are located on the same side of the thermal management component 11. The fluid passage LP includes the first buffer section LP1, a second buffer section LP3, and the main section LP2 that communicates with the first buffer section LP1 and the second buffer section LP3. The first buffer section LP1 communicates with the inlet of the fluid passage LP, and the second buffer section LP3 communicates with the outlet of the fluid passage LP. An orthographic projection of the main section LP2 on the reference plane *M* overlaps with an orthographic projection of the plurality of elements 12 on the reference plane *M*, and the reference plane *M* is a plane perpendicular to the first direction D1. A part of the plurality of insertion members 1322 are inserted into the first buffer section LP1, and another part of the plurality of insertion members 1322 are inserted into the second buffer section LP3.

The comprehension and advantages of the projection relationship between the main section LP2 and the element 12 may be understood with reference to the contents illustrated for the foregoing embodiments, which are not described repeatedly herein. For the comprehension of the first buffer section LP1 and the second buffer section LP3, reference may be made to the first buffer section LP1 illustrated for the foregoing embodiments, which are not described repeatedly herein.

By providing the second buffer section LP3 engaging with the insertion members 1322, the cooling capacity of the coolant flowing into the second buffer section LP3 from the main section LP2 can be further used, thereby further improving the heat exchange effect. Further, by providing the first buffer section LP1 and the second buffer section LP3, the coolant can be buffered before flowing into the main section LP2 and after flowing out of the main section LP2 as well, thereby further improving the flow stability of the coolant in the main section LP2. In the case where there are buffer sections arranged upstream and downstream of the main section LP2 respectively, the coolant in the main section LP2 can more sufficiently exchange heat with the elements 12, thereby improving the heat dissipation effect.

According to some embodiments of the present invention, continuing to refer to FIG. 16, the extending direction of the fluid passage LP from the inlet of the fluid passage LP to the outlet of the fluid passage LP is the reference direction. In the reference direction, the distribution density of the insertion members 1322 per unit of space region in the first buffer section LP1 tends to decrease.

It can be understood with reference to the relevant implementations and advantages about the distribution density of the insertion members 1322 located in the first buffer section LP1 illustrated for the foregoing embodiments, which are not described in detail herein repeatedly.

According to some embodiments of the present invention, continuing to refer to FIG. 16, in the reference direction, the distribution density of the insertion members 1322 per unit space region in the first buffer section LP1 gradually decreases.

It can be understood with reference to the relevant implementations and advantages about the distribution density of the insertion members 1322 located in the first buffer section LP1 illustrated for the foregoing embodiments, which are not described repeatedly in detail herein.

According to some embodiments of the present invention, continuing to refer to FIG. 16, the extending direction of the fluid passage LP from the inlet of the fluid passage LP to the outlet of the fluid passage LP is the reference direction. In the reference direction, the distribution density of the insertion members 1322 per unit space region in the second buffer section LP3 tends to increase.

By setting the distribution density of the insertion members 1322 located in the second buffer section LP3 to tend to increase, the coolant can be blocked and divided to a certain extent, so as to decelerate a part of the coolant with a relatively fast flow rate, and accelerate another part of the coolant with a relatively slow flow rate, thereby achieving a more uniform and stable flow rate of the coolant at the outlet of the fluid passage LP, which is beneficial for improving the stability and reliability of the whole thermal pipeline component. Moreover, by setting the distribution density of the insertion members 1322 to tend to increase, the coolant may form more turbulence and vortices in the second buffer section LP3, thereby promoting mixing of the coolant, which helps to prevent the temperature stratification in the coolant, and make the temperature of the coolant more uniform, thereby further improving the heat exchange efficiency, and also reducing a problem of scaling and other problems caused by local overheating of the coolant.

According to some embodiments of the present invention, continuing to refer to FIG. 16, in the reference direction, the distribution density of the insertion members 1322 per unit space region in the second buffer section LP3 gradually increases.

Referring to what illustrated for some of the foregoing embodiments, as the coolant flows from the inlet of the fluid passage LP to the outlet of the fluid passage LP, a velocity and a pressure thereof gradually decrease. By setting the distribution density of the insertion members 1322 located in the second buffer section LP3 to gradually increase, the insertion members 1322 may be better adapted to the change of the fluid characteristics thereby prolonging the residence time of the coolant in the flow passage while improving the aforementioned temperature equalization, and further forcing the more sufficient heat exchange to be carried out between the coolant in the main section LP2 and the elements 12.

In some other embodiments, in the reference direction, the distribution density of the insertion members 1322 per unit space region in the second buffer section LP3 can be increased by steps. By adjusting the distribution density of the insertion members 1322 by steps, the flow rate, flow direction and turbulence degree of the coolant can be controlled at different stages, which is not specifically limited herein.

It should be noted that, in the case where, in the reference direction, the distribution density of the insertion members 1322 per unit space region in the first buffer section LP1 tends to decrease, and the distribution density of the insertion members 1322 per unit space region in the second buffer section LP3 tends to increase, other advantages may be obtained in addition to the advantages illustrated for the forgoing embodiments. For example, the effect of the heat exchange between the coolant in the main section LP2 and the elements 12 can be improved by the engagement of the first buffer section LP1 and the second buffer section LP3 with the insertion members 1322.

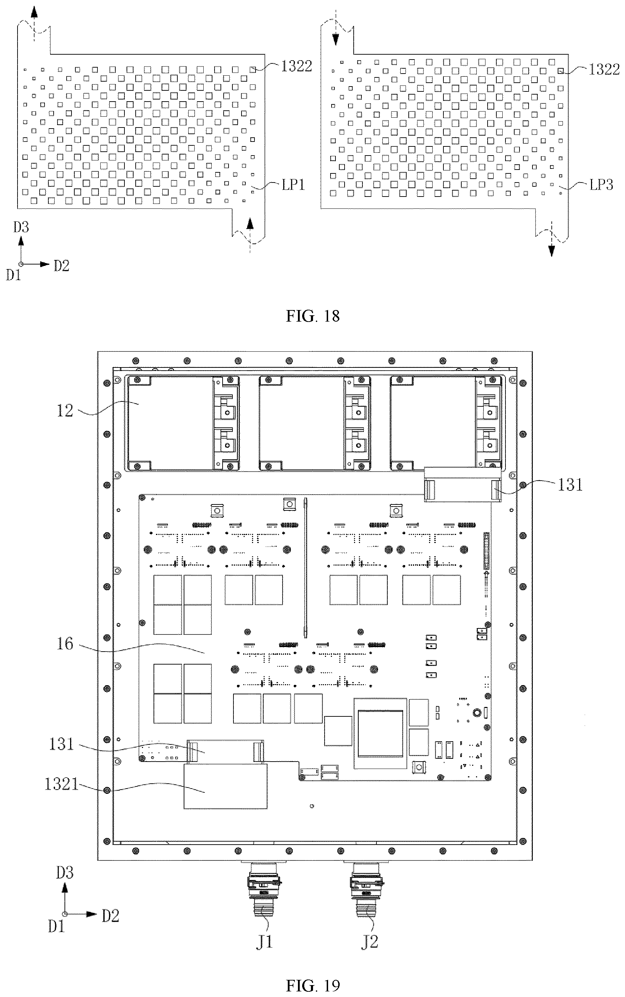

It should also be noted that, in the case where a part of the plurality of insertion members 1322 are inserted into the first buffer section LP1 and another part of the plurality of insertion members 1322 are inserted into the second buffer section LP3, the distribution density of the insertion members 1322 in the first buffer section LP1 and the distribution density of the insertion members 1322 in the second buffer section LP3 may also be implemented in accordance with the implementations, which are related to the distribution density of the insertion members 1322 located in the first buffer section LP1 when all the insertion members 1322 are inserted in the first buffer section LP1, and which is not limited herein. Exemplarily, referring to FIG. 17 and FIG. 18, FIG. 17 is a view illustrating a top viewed structure showing a distribution state of the insertion members according to yet still other embodiments of the present invention, and FIG. 18 is a view illustrating a top viewed structure showing a distribution state of the insertion members according to yet still other embodiments of the present invention. It can be seen that the distribution density of the insertion members 1322 in the first buffer section LP1 tends to increase first and then decrease, and the distribution density of the insertion members 1322 in the second buffer section LP3 tends to increase first and then decrease. In other words, the insertion members 1322 is approximately set sparsely, then set densely, and then set sparsely again in respective buffer sections. In this way, as described above, in addition to the advantages of improving the heat dissipation uniformity and other advantageous described above, not only the clogging issue of the coolant when the coolant comes into contact with and leaves the insertion members can be prevented, but also the heat exchange effect of the airflow can be improved by the coolant exchanging heat with some of the insertion members 1322 in the middle portion.

In addition, continuing to refer to FIG. 17 and FIG. 18, in some embodiments, the insertion members 1322 may be arranged regularly or not, which may be understood by making a reference to the cases illustrated in FIG. 11 to FIG. 14 in the foregoing embodiments, which is not described repeatedly in detail herein.

According to some embodiments of the present invention, continuing to refer to FIG. 5 and FIG. 8, two recess portions recessed in the direction facing away from the first body 111 are formed on the second body 112 of the thermal management component 11. The two recess portions engage with the first body 111 to form the first buffer section LP1 and the second buffer section LP3. Correspondingly, through holes *k* is formed in the first body 111. The insertion members 1322 are inserted into the first buffer section LP1 through the through holes k, and the main body portion 1321 is connected to the first body 111 through sealing.

Since the first buffer section LP1 and the second buffer section LP3 are mainly formed on the second body 112, the space on a side of the second body 112 facing away from the first body 111 can be utilized, which can facilitate the arrangement of the related components on a side of the first body 111 facing away from the second body 112.

In the case where the insertion members 1322 are inserted into the first buffer section LP1 and the second buffer section LP3, two through holes k may be formed in the first body 111, which is not described in detail herein again. Further, in some embodiments, at least a part of the insertion members 1322 among all the insertion members 1322 may be inserted into the first buffer section LP1. Specifically, as illustrated in some forgoing embodiments, it may be the case where all the insertion members 1322 are inserted into the first buffer section LP1; or as illustrated in some forgoing embodiments, it may be the case where a part of all the insertion members 1322 are inserted into the first buffer section LP1, and another part of all the insertion members 1322 are inserted into the second buffer section LP3. Of course, it may also be the case where a part of all the insertion members 1322 are inserted into the first buffer section LP1 or second buffer section LP3, and another part of all the insertion members 1322 are inserted into the main section LP2, which is not limited specifically herein.

According to some embodiments of the present invention, continuing to refer to FIG. 1, FIG. 2 and FIG. 19, FIG. 19 is a view illustrating a top viewed structure of the structure shown in FIG. 2, where the PCS 10 further includes a housing body 14. The housing body 14 has an accommodating cavity. The thermal management component 11 is arranged in the accommodating cavity. The first side f1 of the thermal management component 11 and a cavity wall of the accommodating cavity define a receiving cavity. The plurality of elements 12 and the air-cooling module 13 are arranged in the receiving cavity. A plurality of fans 131 are provided, and all the fans 131 are configured to generate a circulating airflow around an axis in the receiving cavity. The main body portion 1321 is located on the path of the circulating airflow. The extending direction of the axis and the first direction D1 are parallel to each other.

The housing body 14 may include a first portion 141 and a second portion 142 that engage with each other to define the accommodating cavity. FIG. 2 is a schematic view illustrating a structure, where the first portion 141 is removed. The second portion 142 may be provided with an inlet connector J1 communicating with the inlet of the fluid passage LP and an outlet connector J2 communicating with the outlet of the fluid passage LP.

All the fans 131 generate the circulating airflow around the axis. The main body portion 1321 of the radiator 132 is located on the path of the airflow, so that the main body portion 1321 is in sufficient contact with the airflow. Since the circulating airflow can exchange heat with the main body portion 1321 of the radiator 132, the circulating airflow can dissipate heat for the related components disposed on the first side f1 of the thermal management component 11. The combination of the thermal management component 11 and the air cooling of the circulating airflow forms a dual heat dissipation mechanism. The thermal management component 11 can effectively take away a large amount of heat generated by the elements 12, and the engagement between the circulating airflow and the radiator 132, together with the engagement between the radiator 132 and the thermal management component 11, can further improve the heat dissipation of the entire receiving cavity. The two heat dissipation modes cooperate with each other, thereby better meeting the heat dissipation requirements under different working conditions, and improving the heat dissipation performance and adaptability of the PCS 10.

It should be noted that the circulating airflow can form a continuous airflow path around the main body portion 1321 of the radiator 132 and the related heating components, and can completely cover the area where heat dissipation is required. Compared with a conventional linear or local airflow, the circulating airflow can be more sufficiently in contact with the heating surface to take away more heat, thereby improving the heat dissipation efficiency and improving the temperature equalization of the whole device.

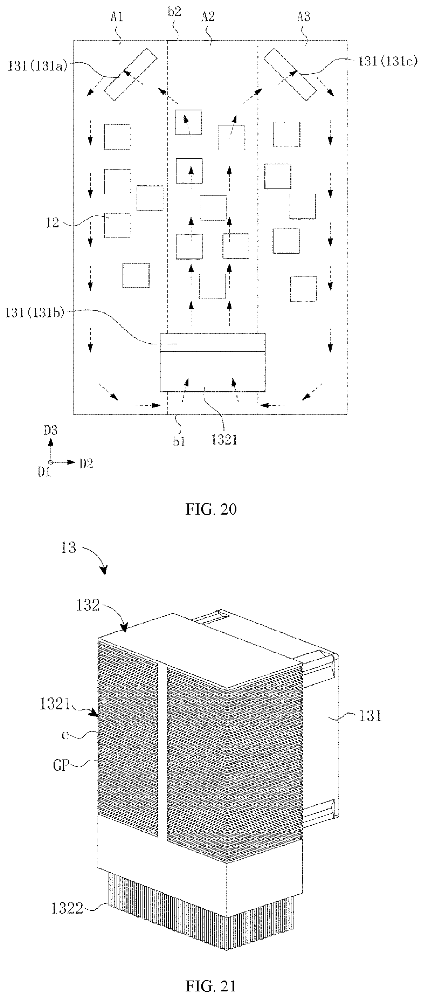

According to some embodiments of the present invention, referring to FIG. 20, FIG. 20 is a schematic view illustrating a structure having a plurality of fans 131, which cooperate with each other to form a circulating airflow, according to some embodiments of the present invention, where at least three fans 131 are provided. The fans 131 are configured to generate two circulating airflows arranged in a second direction D2 in the receiving cavity. The first direction D1 and the second direction D2 intersect with each other.

Exemplarily, referring to FIG. 20, the arrangement of the two circulating airflows in the second direction D2 is illustrated. The first direction D1 and the second direction D2 may be perpendicular to each other.

By forming two circulating airflows, a more uniform airflow distribution can be formed in the receiving cavity to fully cover the relevant components requiring heat dissipation, thereby preventing the formation of a heat dissipation dead zone, and improving the heat dissipation efficiency.

According to some embodiments of the present invention, continuing to refer to FIG. 20, the thermal management component 11 has a first area A1, a second area A2 and a third area A3 arranged along the second direction D2. All the fans 131 are arranged in the first area A1, the second area A2 and the third area A3. The fan 131 disposed in the first area A1 is defined as a first fan 131a, the fan 131 disposed in the second area A2 is defined as a second fan 131b, and the fan 131 disposed in the third area A3 is defined as a third fan 131c. The main body portion 1321 is located on a path of an airflow generated by the second fan 131b. The first fan 131a and the second fan 131b are configured to generate a circulating airflow, and the second fan 131b and the third fan 131c are configured to generate another circulating airflow.

In FIG. 20, the first area A1, the second area A2, and the third area A3 are illustrated with dashed lines, but they are not limited thereto. The thermal management component 11 may have physical boundaries to form different areas, or no physical boundaries are provided to distinguish different areas from each other.

Since the main body portion 1321 is located on the path of the airflow generated by the second fan 131b, the second fan 131b can directly dissipate heat for the main body portion 1321. By generating two circulating airflows through the cooperation between the first fan 131a and the second fan 131b and the cooperation between the second fan 131b and the third fan 131c, the airflows can be more evenly distributed in different areas of the thermal management component 11, thereby improving the situation of local overheating, and further improving the overall temperature equalization. Since the second fan 131b, together with the first fan 131a and the third fan 131c respectively, can form circulating airflows, and the two circulating airflows converge and are mixed in the second area A2, which increases the flow speed and the disturbance degree of the air in the second area A2 and enables the heat in the second area A2 to be taken away more quickly by the airflow, thereby improving the heat exchange efficiency, and facilitating the heat dissipation of the heat generating components in the second area A2.

According to some embodiments of the present invention, continuing to refer to FIG. 20, a plurality of elements 12 are arranged in the first area A1, second area A2, and third area A3. The average heat generation of all the elements 12 provided in the first area A1 and the average heat generation of all the elements 12 provided in the third area A3 are both less than the average heat generation of all the elements 12 provided in the second area A2.

In the embodiments of the present invention, the heat generation refers to the heat quantity generated by the elements 12 when the elements 12 operate under the rated voltage until comes into a stable state, in which the heat generation is relatively stable. Taking all elements 12 provided in the first area A1 as an example, the rated voltages corresponding to all elements 12 provided in the first area A1 may be different or the same. The average heat generation of all elements 12 provided in the first area A1 may be an average value of the heat generations corresponding to all elements 12 provided in the first area A1 when all elements 12 provided in the first area A1 operate under the rated voltage until come into the stable state. The average heat generation of all elements 12 provided in the second area A2, and the average heat generation of all elements 12 provided in the third area A3 may be understood with reference to the average heat generation of all elements 12 provided in the first area A1, and are not described herein again.

The elements 12 with small heat generation is less affected by the ambient temperature, so that, by arranging the elements 12 with large heat generation and the elements 12 with small heat generation in respective zones, the thermal interference of the elements 12 with large heat generation in the elements 12 with small heat generation can be reduced. Compared with the first area A1 and the third area A3, the heat in the second area A2 can be taken away more quickly by the airflow. Therefore, by arranging the elements 12 with relatively large heat generation in the second area A2 and arranging the elements 12 with relatively small heat generation in the first area A1 and the third area A3, the two circulating airflows can be better used to dissipate heat in different areas, thereby improving the heat dissipation effect.

According to some embodiments of the present invention, referring to FIG. 21, FIG. 21 is a schematic view illustrating a three-dimensional structure having the radiator 132 and the second fan 131b engaging with each other according to some embodiments of the present invention. The main body portion 1321 includes at least one column of multiple fins *e* arranged at intervals along the first direction D1, and each column of fins *e* defines spacing channels *GP*. An inlet side of the second fan 131b is connected to a side of the main body portion 1321, and the inlet of the second fan 131b communicates with the spacing channels *GP*.

One column, two or more columns of fins *e* may be arranged, which is not specifically limited herein. Taking FIG. 21 as an example, it is illustrated that two columns of fins *e* are arranged.

In this way, the airflow would pass through the spacing channels *GP* first before entering the inlet side of the second fan 131b. That is, the fins *e* divide the airflow before the airflow enters the inlet side of the second fan 131b, so that the airflow can contact each part of the main body portion 1321 of the radiator 132 more uniformly, and the actual contact area between the airflow and the fins *e* is increased. More airflow is in contact with the surface of the fins *e*, thereby accelerating the heat exchange between the main body portion 1321 of the radiator 132 and the airflow, and improving the overall heat dissipation efficiency. Moreover, the airflow divided by the fins *e* can better break the boundary layer of the airflow, thereby reducing the thermal resistance, and further improving the heat exchange effect.

It should be noted that, each fin *e* may be configured as a flat sheet-shaped structure, a wavy sheet-shaped structure, or an inclined sheet-shaped structure. Sizes of the spacing channels *GP* each formed by every two adjacent fins *e* may be different, may be identical, or may be partially identical, which is not limited specifically herein.

According to some embodiments of the present invention, continuing to refer to FIG. 20, the thermal management component 11 has a first edge b1 and a second edge b2 opposite to each other in the third direction D3. The first direction D1, the second direction D2, and the third direction D3 intersect with each other. Compared with the second edge b2, the second fan 131b is disposed closer to the first edge b1. Compared with the first edge b1, the first fan 131a and the third fan 131c are disposed closer to the second edge b2.

Exemplarily, in the embodiments of the present invention, the first direction D1, the second direction D2, and the third direction D3 are perpendicular to each other.

This arrangement allows the airflow generated by the fans 131 to cover more areas. Through the cooperation of the fans 131, the airflow can circulation better, so that the air can flow sufficiently, thereby dissipating the heat in each area, and further improving the overall heat dissipation effect.

According to some embodiments of the present invention, continuing to refer to FIG. 2, FIG. 3 and FIG. 7, the main body portion 1321 includes at least one column of multiple fins *e* arranged at intervals along the first direction D1, and each column of fins *e* defines spacing channels *GP*. The inlet side of one of the fans 131 is connected to a side of the main body portion 1321, and the inlet of the one of the fans 131 communicates with the spacing channels *GP*.

The inlet side of the fan 131 is connected to a side of the main body portion 1321 and the inlet of the fan 131 communicates with the spacing channels *GP*, thus achieving beneficial effects which may be understood with reference to the advantages of the inlet side of the second fan 131b being connected to a side of the main body portion 1321, and which are not described herein in detail again.

In the case where the inlet side of the fan 131 is connected to the side of the main body portion 1321 and the inlet of such fan 131 communicates with the spacing channels *GP*, during a cooperation to control the distribution density of the insertion members 1322 in the first buffer section LP1, the heat exchange effects of different portions of the main body portion 1321 in contact with the insertion members 1322 are different due to the different distribution densities of the insertion members 1322. In a region where the distribution density of the insertion members 1322 is larger, the contact area between the insertion members 1322 and the coolant is larger, and the heat exchange is more sufficient, thus the temperature of a corresponding portion of the main body portion 1321 would be lower. In a region where the distribution density of the insertion members 1322 is smaller, the heat exchange is relatively insufficient, thus the temperature of a corresponding portion of the main body portion 1321 would be relatively high. Different temperatures of different portions of the main body portion 1321 may cause different convection conditions when the airflow passes through. In a region with a higher temperature, the air expands due to heat and becomes smaller in density, thus generating upward convection movement and attracting the surrounding air to flow to such region, so that the airflow speed would be faster. In a region with a lower temperature, the air density is greater, the airflow is relatively stable, and even a local air sinking may occur, so that the airflow speed would be slower. In this way, when the air flows through different portions of the main body portion 1321 with different temperatures, the direction and speed of the airflows may change to form a more complex convection, which would facilitate the mixing of the airflows. It would be understood that, the closer the airflow is to the inlet of the fan 131, the faster the speed of the airflow, so that a more uniform airflow may be formed in cooperation with the main body portion 1321 with temperature difference, thereby improving the heat dissipation effect of the airflow on the corresponding components.

In the case where the insertion members 1322 in the first buffer section LP1 and the insertion members 1322 in the second buffer section LP3 respectively have the distribution densities illustrated in some forgoing embodiments, by cooperating with the arrangement of the inlet side of the fan 131 being connected to the side of the main body portion 1321, beneficial effects can be achieved as illustrated above and are not described herein again. Different from the case where only the distribution density of the insertion members 1322 in the first buffer section LP1 is controlled, this embodiment can improve the overall temperature equalization due to the further cooperation between the first buffer section LP1 and the second buffer section LP3.

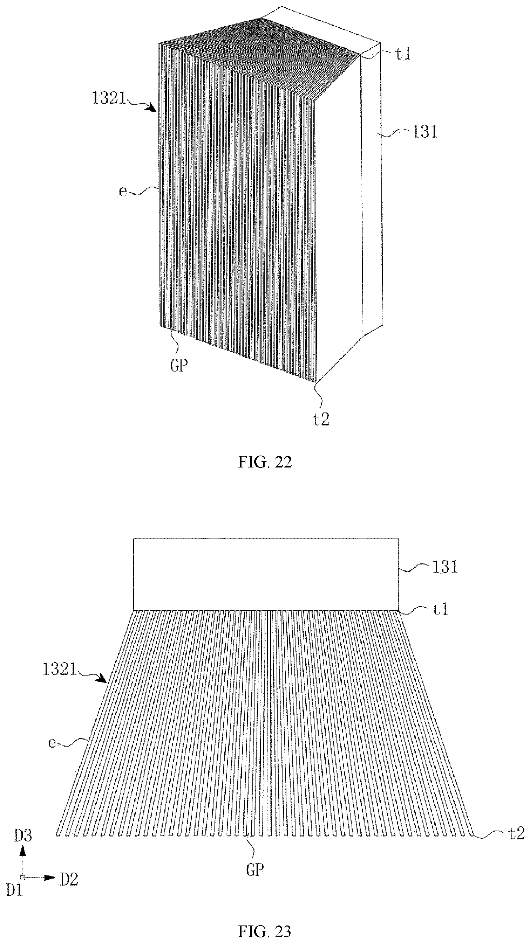

According to some embodiments of the present invention, referring to FIG. 22 and FIG. 23, FIG. 22 is a three-dimensional structural view showing a main body portion 1321 of a radiator 132 and a fan 131 engaging with each other according to other embodiments of the present invention, and FIG. 23 is a view illustrating a top viewed structure of the main body portion 1321 of the radiator 132 and the fan 131 engaging with each other according to other embodiments of the present invention. The main body portion 1321 includes a plurality of fins e arranged at intervals along the second direction D2. A spacing channel *GP* is defined between every two adjacent fins *e* in the second direction D2. The fan 131 is connected to a side of the main body portion 1321 in the third direction D3. The inlet side of the fan 131 is arranged to face the main body portion 1321, and the inlet of such fan 131 communicates with the spacing channels *GP*. Each fin e extends longitudinally in the first direction D1, and each fin *e* has a first end t1 and a second end t2 opposite to each other in the third direction D3. The first end t1 of each fin *e* faces the fan 131, and the second end t2 of each fin *e* faces away from the fan 131. The first ends t1 of all the fins *e* are close to each, and the second ends t2 of all the fins *e* are distributed in a divergent manner.

Since the first ends of all fins *e* are close to each and the second ends of all fins are distributed in a divergent manner, each of the spacing channels *GP* gradually becomes wider in a direction away from the inlet of the fan 131. As a result, when the airflow enters the spacing channels *GP* from the second end t2 of the fins *e*, the speed of the airflow is slower than that of the airflow close to the inlet of the fan 131, so that the residence time of the airflow can be increased, and the heat exchange between the airflow and the fins *e* is more sufficient. Thus, the varying flow speed and the increased residence time contribute to more efficient heat exchange between the airflow and the fins *e*, thereby improving the overall heat dissipation efficiency.

According to some embodiments of the present invention, continuing to refer to FIG. 3 and FIG. 4, the first side f1 of the thermal management component 11 includes a plurality of installation areas X. The PCS 10 further includes a plurality of temperature equalization plates 15. The plurality of temperature equalization plates 15 are arranged in the plurality of installation areas *X* in a one-to-one correspondence. The temperature equalization plates 15 are disposed in the corresponding installation areas *X*. The plurality of temperature equalization plates 15 are arranged in a one-to-one correspondence with at least some of the plurality of elements 12. The corresponding element 12 is installed on a side of the temperature equalization plate 15 facing away from the thermal management component 11. It should be noted that, in FIG. 3 and FIG. 4, the elements 12 disposed on the temperature equalization plates 15 are not shown.

Each temperature equalization plate 15 is a plate-shaped heat dissipating element with efficient heat conduction capability, and is usually made of a material with high thermal conductivity, such as copper, aluminum or any other metal, or any of some high-performance composite materials. The temperature equalization plate 15 realizes a rapid heat transfer and a heat homogenization by means of internal phase change materials or a structure with high thermal conductivity. When a side of the temperature equalization plate 15 contacts the element 12, the heat will be rapidly transmitted to the whole temperature equalization plate 15 through the plate material. At the same time, the phase change material inside the temperature equalization plate 15 will absorb the heat in a high-temperature area and change its phase, and then release the heat in a low-temperature area and reversely change its phase. In this way, the rapid heat transfer and heat homogenization are realized, so that the temperature difference of the surface of the temperature equalization plate 15 is extremely small, thereby achieving the effect of temperature equalization.

Exemplarily, the element 12 may be an Insulated Gate Bipolar Transistor (IGBT). Of course, the element 12 may also be an inductance, which is not specifically limited herein.

In this way, by providing the temperature equalization plates 15, not only the temperature distribution on the surface of the element 12 can be more uniform, so that the performance stability and reliability of the element can be improved, and the thermal stress and the aging of the element which are caused by the uneven temperature distribution can be reduced; but also the heat generated by the element 12 can be rapidly transferred to the thermal management component 11, so that the heat can be taken away by the coolant in the thermal management component 11, thereby effectively improving the heat dissipation efficiency.

It should be noted that, the temperature equalization plate 15 may be embedded in the first side f1 of the thermal management component 11. The temperature equalization plate 15 may be arranged to be aligned with the thermal management component 11, or may be arranged to protrude from the thermal management component 11, which is not specifically limited herein. The temperature equalization plate 15 may be connected to the thermal management component 11 by means of thermally conductive adhesive. Of course, the temperature equalization plate 15 may also be connected to the thermal management component 11 by welding, which is not limited specifically herein.

In some embodiments, continuing refer to FIG. 2, the PCS 10 further includes a circuit board assembly 16 disposed on the first side f1 of the thermal management component 11. The circuit board assembly 16 includes a circuit board and some components disposed on the circuit board. The circuit board assembly 16 may be used to realize electrical connection between the elements 12. Of course, the PCS 10 may also include other components, which are not specifically limited herein.

According to some embodiments of the present invention, continuing to refer to FIG. 1, the PCS 10 may have at least one of a photovoltaic interface, a battery interface, a power grid input interface, a direct current (DC) output interface, and an alternating current (AC) output interface. The solar cells or other renewable energy generation systems can be connected to the PCS 10 through the photovoltaic interface. The PCS 10 is connected to the battery through the battery interface. The battery can store electric energy, thus facilitating the conversion and output of the electric energy of battery through the PCS 10. the high-voltage electric energy of the power grid is inputted through the power grid input interface, so that the high-voltage electric energy, after being stepped down through the PCS 10, can be output to a low-voltage power equipment or system. The AC output interface may be connected to household appliances and other products requiring AC power, and the PCS 10 converts AC power into DC power and outputs it to the appliances. The DC output interface may be connected to a charging pile and other equipment requiring DC power.

In this way, the PCS 10 may be flexibly set according to the actual use requirements, thereby improving the adaptability of the PCS 10 to meet the use requirements in different scenarios, which are not specifically limited herein.

According to some embodiments of the present invention, an energy storage system is provided. The energy storage system includes the PCS 10 of any one of the above embodiments.

In some embodiments, the energy storage system further includes a battery. The PCS 10 is electrically connected with the battery. The PCS 10 can convert the energy generated from solar energy, wind energy or fuel cell into DC power, store it in the battery, and output the electric energy stored in the battery when necessary. The energy storage system can provide reliable energy storage for a user, and provide a backup power supply for the user when the power is cut off or insufficient.

The energy storage system also has the advantages of the PCS 10, which are not described repeatedly herein.

## Claims

1. A power conversion system (PCS, 10), **characterized by**, comprising:
a thermal management component (11) having a fluid passage (LP), and having a first side (f1) and a second side (f2) opposite to each other along a first direction (D1);
a plurality of elements (12) disposed on the first side (f1); and
an air-cooling module (13) disposed on the first side (f1), wherein the air-cooling module (13) comprises a fan (131) and a radiator (132), the radiator (132) comprises a main body portion (1321) and a plurality of insertion members (1322) arranged at intervals, the main body portion (1321) is located on a path of an airflow generated by the fan (131), the plurality of insertion members (1322) are disposed on a side of the main body portion (1322) facing the thermal management component (11) along the first direction (D1), and the plurality of insertion members (1322) are configured to be inserted into the fluid passage (LP).

2. The PCS (10) according to claim 1, wherein the fluid passage (LP) comprises a first buffer section (LP1) and a main section (LP2), the first buffer section communicates with an inlet of the fluid passage (LP), the main section (LP2) communicates with the first buffer section (LP1) and an outlet of the fluid passage (LP);
an orthographic projection of the main section (LP2) on a reference plane (*M*) overlaps with an orthographic projection of the plurality of elements (12) on the reference plane (*M*), and the reference plane (M) is perpendicular to the first direction (D1); and
the plurality of insertion members (1322) are configured to be inserted into the first buffer section (LP1).

3. The PCS (10) according to claim 2, wherein an extending direction of the fluid passage (LP) from the inlet of the fluid passage (LP) to the outlet of the fluid passage (LP) is a reference direction; and
in the reference direction, a distribution density of the plurality of insertion members (1322) per unit space region in the fluid passage (LP) tends to decrease;
optionally, in the reference direction, the distribution density of the plurality of insertion members (1322) per unit space region in the fluid passage (LP) decreases by steps.

4. The PCS (10) according to claim 1, wherein an inlet of the fluid passage (LP) and an outlet of the fluid passage (LP) are located on the same side of the thermal management component (11);
the fluid passage (LP) comprises a first buffer section (LP1), a second buffer section (LP3), and a main section (LP2) that communicates with the first buffer section (LP1) and the second buffer section (LP3); the first buffer section (LP1) communicates with the inlet of the fluid passage (LP), and the second buffer section (LP3) communicates with the outlet of the fluid passage (LP); an orthographic projection of the main section (LP2) on a reference plane (M) overlaps with an orthographic projection of the plurality of elements (12) on the reference plane (M); and the reference plane (M) is perpendicular to the first direction (D1); and
a part of the plurality of insertion members (1322) are configured to be inserted into the first buffer section (LP1), and another part of the plurality of insertion members (1322) are configured to be inserted into the second buffer section (LP3).

5. The PCS (10) according to claim 4, wherein an extending direction of the fluid passage (LP) from the inlet of the fluid passage (LP) to the outlet of the fluid passage (LP) is a reference direction; and
in the reference direction, a distribution density of the part of the plurality of insertion members (1322) per unit space region in the first buffer section (LP1), tends to decrease;
optionally, in the reference direction, the distribution density of the part of the plurality of insertion members (1322) per unit space region in the first buffer section (LP1) decreases by steps.

6. The PCS (10) according to claim 4, wherein an extending direction of the fluid passage (LP) from the inlet of the fluid passage (LP) to the outlet of the fluid passage (LP) is a reference direction; and
in the reference direction, a distribution density of the other part of the plurality of insertion members (1322) per unit space region in the second buffer section (LP3) tends to increase;
optionally, in the reference direction, a distribution density of the other part of the plurality of insertion members (1322) per unit space region in the second buffer section (LP3) increases by steps.

7. The PCS (10) according to any one of claims 1 to 6, further comprises a housing body (14); the housing body (14) has an accommodating cavity, and the thermal management component (11) is disposed in the accommodating cavity; the first side (f1) of the thermal management component (11) and a cavity wall of the accommodating cavity define a receiving cavity, and the plurality of elements (12) and the air-cooling module (13) are disposed in the receiving cavity; and
a plurality of fans (131) are provided, the plurality of fans (131) are configured to generate a circulating airflow around an axis in the receiving cavity, the main body portion (1321) is located on a path of the circulating airflow, and an extending direction of the axis and the first direction (D1) are parallel to each other.

8. The PCS (10) according to claim 7, wherein at least three fans (131) are provided, and the at least three fans (131) are configured to generate two circulating airflows arranged in a second direction (D2) in the receiving cavity, and the first direction (D1) and the second direction (D2) intersect with each other.

9. The PCS (10) according to claim 8, wherein the thermal management component (11) has a first area (A1), a second area (A2) and a third area (A3) arranged along the second direction (D2), the at least three fans (131) are arranged in the first area (A1), the second area (A2), and the third area (A3);
a fan (131) disposed in the first area (A1) is defined as a first fan (131a), a fan (131) disposed in the second area (A2) is defined as a second fan (131b), and a fan (131) disposed in the third area (A3) is defined as a third fan (131c); and
the main body portion (1321) is located on a path of an airflow generated by the second fan (131b), the first fan (2a) and the second fan (131b) are configured to generate a circulating airflow, and the second fan (3b) and the third fan (131c) are configured to generate another circulating airflow.

10. The PCS (10) according to claim 9, wherein the plurality of elements (12) are arranged in the first area (A1), the second area (A2), and the third area (A3); and
an average heat generation of elements (12) provided in the first area (A1) and an average heat generation of elements (12) provided in the third area (A3) are both less than an average heat generation of elements (12) provided in the second area (A2).

11. The PCS (10) according to claim 9, wherein the main body portion (1321) comprises at least one column of fins (e) arranged at intervals along the first direction (D1), and each column of fins (e) defines spacing channels (GP); and
an inlet side of the second fan (131b) is connected to a side of the main body portion (1321), and an inlet of the second fan (131b) communicates with the spacing channels (GP).

12. The PCS (10) according to claim 9, wherein the thermal management component (11) has a first edge (b1) and a second edge (b2) opposite to each other in a third direction (D3); the first direction (D1), the second direction (D2), and the third direction (D3) intersect with each other; and
the second fan (131b) is disposed closer to the first edge (b1) than to the second edge (b2); and the first fan (131a) and the third fan (131c) are disposed closer to the second edge (b2) than to the first edge (b1).

13. The PCS (10) according to claim 7, wherein the main body portion (1321) comprises at least one column of fins (e) arranged at intervals along the first direction (D1), and each column of fins (e) defines spacing channels (GP); and
an inlet side of one of the plurality of fans (131) is connected to a side of the main body portion (1321), and an inlet of the one of the plurality of fans (131) communicates with the spacing channels (GP).

14. The PCS (10) according to any one of claims 1 to 6, wherein the first side (f1) of the thermal management component (11) comprises a plurality of installation areas (X), the PCS (10) further comprises a plurality of temperature equalization plates (15), the plurality of temperature equalization plates (15) are arranged in the plurality of installation areas (X) in a one-to-one correspondence; and
the plurality of temperature equalization plates (15) are arranged in a one-to-one correspondence with at least some of the plurality of elements (12), and each of the least some of the plurality of elements (12) is installed on a side of a corresponding temperature equalization plate (15) facing away from the thermal management component (11).

15. An energy storage system, **characterized by** comprising the PCS (10) according to any one of claims 1 to 14.

## Amended claims

### Amended claims in accordance with Rule 137(2) EPC.

1. A power conversion system (PCS, 10), **characterized by**, comprising:
a thermal management component (11) having a fluid passage (LP), and having a first side (f1) and a second side (f2) opposite to each other along a first direction (D1);
a plurality of elements (12) disposed on the first side (f1); and
an air-cooling module (13) disposed on the first side (f1), wherein the air-cooling module (13) comprises a fan (131) and a radiator (132), the radiator (132) comprises a main body portion (1321) and a plurality of insertion members (1322) arranged at intervals, the main body portion (1321) is located on a path of an airflow generated by the fan (131), the plurality of insertion members (1322) are disposed on a side of the main body portion (1322) facing the thermal management component (11) along the first direction (D1), and the plurality of insertion members (1322) are inserted into the fluid passage (LP).

2. The PCS (10) according to claim 1, wherein the fluid passage (LP) comprises a first buffer section (LP1) and a main section (LP2), the first buffer section communicates with an inlet of the fluid passage (LP), the main section (LP2) communicates with the first buffer section (LP1) and an outlet of the fluid passage (LP);
an orthographic projection of the main section (LP2) on a reference plane (M) overlaps with an orthographic projection of the plurality of elements (12) on the reference plane (M), and the reference plane (M) is perpendicular to the first direction (D1); and
the plurality of insertion members (1322) are inserted into the first buffer section (LP1).

3. The PCS (10) according to claim 2, wherein an extending direction of the fluid passage (LP) from the inlet of the fluid passage (LP) to the outlet of the fluid passage (LP) is a reference direction; and
in the reference direction, a distribution density of the plurality of insertion members (1322) per unit space region in the fluid passage (LP) decreases;
optionally, in the reference direction, the distribution density of the plurality of insertion members (1322) per unit space region in the fluid passage (LP) decreases by steps.

4. The PCS (10) according to claim 1, wherein an inlet of the fluid passage (LP) and an outlet of the fluid passage (LP) are located on the same side of the thermal management component (11);
the fluid passage (LP) comprises a first buffer section (LP1), a second buffer section (LP3), and a main section (LP2) that communicates with the first buffer section (LP1) and the second buffer section (LP3); the first buffer section (LP1) communicates with the inlet of the fluid passage (LP), and the second buffer section (LP3) communicates with the outlet of the fluid passage (LP); an orthographic projection of the main section (LP2) on a reference plane (M) overlaps with an orthographic projection of the plurality of elements (12) on the reference plane (M); and the reference plane (M) is perpendicular to the first direction (D1); and
a part of the plurality of insertion members (1322) are inserted into the first buffer section (LP1), and another part of the plurality of insertion members (1322) are inserted into the second buffer section (LP3).

5. The PCS (10) according to claim 4, wherein an extending direction of the fluid passage (LP) from the inlet of the fluid passage (LP) to the outlet of the fluid passage (LP) is a reference direction; and
in the reference direction, a distribution density of the part of the plurality of insertion members (1322) per unit space region in the first buffer section (LP1) decreases;
optionally, in the reference direction, the distribution density of the part of the plurality of insertion members (1322) per unit space region in the first buffer section (LP1) decreases by steps.

6. The PCS (10) according to claim 4, wherein an extending direction of the fluid passage (LP) from the inlet of the fluid passage (LP) to the outlet of the fluid passage (LP) is a reference direction; and
in the reference direction, a distribution density of the other part of the plurality of insertion members (1322) per unit space region in the second buffer section (LP3) increases;
optionally, in the reference direction, a distribution density of the other part of the plurality of insertion members (1322) per unit space region in the second buffer section (LP3) increases by steps.

7. The PCS (10) according to any one of claims 1 to 6, further comprises a housing body (14);
the housing body (14) has an accommodating cavity, and the thermal management component (11) is disposed in the accommodating cavity; the first side (f1) of the thermal management component (11) and a cavity wall of the accommodating cavity define a receiving cavity, and the plurality of elements (12) and the air-cooling module (13) are disposed in the receiving cavity; and
a plurality of fans (131) are provided, the plurality of fans (131) are configured to generate a circulating airflow around an axis in the receiving cavity, the main body portion (1321) is located on a path of the circulating airflow, and an extending direction of the axis and the first direction (D1) are parallel to each other.

8. The PCS (10) according to claim 7, wherein at least three fans (131) are provided, and the at least three fans (131) are configured to generate two circulating airflows arranged in a second direction (D2) in the receiving cavity, and the first direction (D1) and the second direction (D2) intersect with each other.

9. The PCS (10) according to claim 8, wherein the thermal management component (11) has a first area (A1), a second area (A2) and a third area (A3) arranged along the second direction (D2), the at least three fans (131) are arranged in the first area (A1), the second area (A2), and the third area (A3);
a fan (131) disposed in the first area (A1) is defined as a first fan (131a), a fan (131) disposed in the second area (A2) is defined as a second fan (131b), and a fan (131) disposed in the third area (A3) is defined as a third fan (131c); and
the main body portion (1321) is located on a path of an airflow generated by the second fan (131b), the first fan (2a) and the second fan (131b) are configured to generate a circulating airflow, and the second fan (3b) and the third fan (131c) are configured to generate another circulating airflow.

10. The PCS (10) according to claim 9, wherein the plurality of elements (12) are arranged in the first area (A1), the second area (A2), and the third area (A3); and
an average heat generation of elements (12) provided in the first area (A1) and an average heat generation of elements (12) provided in the third area (A3) are both less than an average heat generation of elements (12) provided in the second area (A2).

11. The PCS (10) according to claim 9, wherein the main body portion (1321) comprises at least one column of fins (e) arranged at intervals along the first direction (D1), and each column of fins (e) defines spacing channels (GP); and
an inlet side of the second fan (131b) is connected to a side of the main body portion (1321), and an inlet of the second fan (131b) communicates with the spacing channels (GP).

12. The PCS (10) according to claim 9, wherein the thermal management component (11) has a first edge (b1) and a second edge (b2) opposite to each other in a third direction (D3); the first direction (D1), the second direction (D2), and the third direction (D3) intersect with each other; and
the second fan (131b) is disposed closer to the first edge (b1) than to the second edge (b2); and the first fan (131a) and the third fan (131c) are disposed closer to the second edge (b2) than to the first edge (b1).

13. The PCS (10) according to claim 7, wherein the main body portion (1321) comprises at least one column of fins (e) arranged at intervals along the first direction (D1), and each column of fins (e) defines spacing channels (GP); and
an inlet side of one of the plurality of fans (131) is connected to a side of the main body portion (1321), and an inlet of the one of the plurality of fans (131) communicates with the spacing channels (GP).

14. The PCS (10) according to any one of claims 1 to 6, wherein the first side (fl) of the thermal management component (11) comprises a plurality of installation areas (X), the PCS (10) further comprises a plurality of temperature equalization plates (15), the plurality of temperature equalization plates (15) are arranged in the plurality of installation areas (X) in a one-to-one correspondence; and
the plurality of temperature equalization plates (15) are arranged in a one-to-one correspondence with at least some of the plurality of elements (12), and each of the least some of the plurality of elements (12) is installed on a side of a corresponding temperature equalization plate (15) facing away from the thermal management component (11).

15. An energy storage system, **characterized by** comprising the PCS (10) according to any one of claims 1 to 14.
